# EUROPÄISCHE PATENTSCHRIFT

(11) **EP 1 390 987 B1**
(45) Veröffentlichungstag und Bekanntmachung des Hinweises auf die Patenterteilung: **22.11.2006**
(21) Anmeldenummer: 02712887.5
(22) Anmeldetag: 01.02.2002
(51) Int. Cl.: H01L 31/18, H01L 31/068, H01L 21/311

(54) **VERFAHREN ZUR STRUKTURIERUNG EINER AUF EINEM TRÄGERMATERIAL AUFGEBRACHTEN OXIDSCHICHT**
METHOD FOR STRUCTURING AN OXIDE LAYER APPLIED TO A SUBSTRATE MATERIAL
PROCEDE DE STRUCTURATION D'UNE COUCHE D'OXYDE APPLIQUEE SUR UN MATERIAU SUBSTRAT

(30) Priorität: 02.02.2001 DE 10104726
(43) Veröffentlichungstag der Anmeldung: 25.02.2004
(73) Patentinhaber: Shell Solar GmbH, 81739 München (DE)
(72) Erfinder: MÜNZER, Adolf, 85716 Lohhof (DE); SCHLOSSER, Reinhold, 80993 München (DE)
(74) Vertreter: Rau, Albrecht
(86) Internationale Anmeldenummer: PCT/EP2002/001096
(87) Internationale Veröffentlichungsnummer: WO 2002/061854

(56) Entgegenhaltungen:
- DE-A- 4 426 347
- US-A- 5 894 853
- US-A- 5 899 704
- PATENT ABSTRACTS OF JAPAN vol. 011, no. 174 (E-513), 4. Juni 1987 (1987-06-04) & JP 62 009680 A (HITACHI LTD), 17. Januar 1987 (1987-01-17)
- PATENT ABSTRACTS OF JAPAN vol. 1997, no. 11, 28. November 1997 (1997-11-28) & JP 09 191118 A (SHIN ETSU CHEM CO LTD), 22. Juli 1997 (1997-07-22)

## Beschreibung

Die Erfindung betrifft eine Solarzelle und ein Verfahren zu ihrer Herstellung.

Eine kristalline Silizium-Solarzelle besteht üblicherweise aus einem p-leitenden Substrat, in das auf der Vorderseite eine homogen dicke Schicht einer n-leitenden Substanz, beispielsweise Phosphor, eindiffundiert wird. Auf der Vorder- und der Rückseite des Wafers wird zur Ableitung des unter Lichteinfall erzeugten Stroms eine metallisch leitende Kontaktierung aufgebracht. Im Hinblick auf eine kostengünstige und massenfertigungstaugliche Herstellungsweise wird die Kontaktierung üblicherweise mittels der Siebdrucktechnik erzeugt.

In dem USA Patent Nr. 5 899 704 ist eine Solarzelle nach dem Stand der Technik und ein Verfahren zu ihrer Herstellung beschrieben. Die Lichteinfallseite eines p-dotierten Silizium-Wafer ist mit einer Emitterschicht mit einer hohen n-Dotierung (n+ -Dotierung) versehen, auf welcher Kontakte angebracht sind. Auf der Rückseite wird ein sogenanntes Back-Surface-Field erzeugt. Das bekannte Verfahren umfasst die Schritte
- Bereitstellen eines p-dotierten Silizium-Wafers mit einer Lichteinfallseite und einer Rückseite;
- Erzeugen einer Oxidschicht auf dem p-dotierten Silizium-Wafer;
- Aufbringen einer Diffusionsquellschicht, die Bor als Dotierstoff enthält, auf der Rückseite des Silizium-Wafers, wobei das Silizium-Wafer in einer Sauerstoff enthaltenden Atmosphäre bei einer Temperatur von 900 bis 1200°C behandelt wird zum Erzeugen der Oxidschicht und zum Eintreiben des Dotierstoffs;
- Entfernen der Oxidschicht;
- Einbringen einer ganzflächig hohen n-Dotierung auf der Lichteinfallseite und der Rückseite; und
- Kontaktierung der Lichteinfallseite und der Rückseite.

Bei der Höhe der n-Dotierung müssen zwei an sich entgegengesetzte Randbedingungen in Einklang gebracht werden.

Dokument US-A 5,894,853 beschreibt ein Verfahren zur Strukturierung einer Oxidschicht. Dokument JP 09191118 beschreibt ein Verfahren zur Herstellung einer Solarzelle die eine Schicht mit organischem Ti enthält.

Zur Anwendung der Siebdrucktechnik für den Vorderseitenkontakt ist es wichtig, eine ausreichend hohe n-Dotierung vorzusehen. Ist die Dotierung des Siliziums zu niedrig, so wird der Übergangswiderstand zwischen dem Silizium und der Kontaktierung zu hoch. Dies hätte zur Folge, dass der Serienwiderstand der Solarzelle ansteigt, was dann zu einem sinkenden Füllfaktor der Hellkennlinie der Solarzelle führt. Auf der anderen Seite führt eine zu hohe n-Dotierung zu einer Erniedrigung der Blauempfindlichkeit der Solarzelle, was eine frühzeitige Rekombination von Ladungsträgern und damit eine Absinkung des Wirkungsgrads zur Folge hätte.

Bei einer industriell nach dem Stand der Technik hergestellten Solarzelle wird die Vorderseite mit Siebdrucktechnik kontaktiert. Dies erfordert eine Dicke der diffundierten n-Schicht von ca. 0.3 µm mit einer Phosphor-Oberflächenkonzentration im Bereich von 10E20 Atomen/cm³. Durch die Tiefe und die Oberflächenkonzentration der n+-Schicht wird auch ihre Empfindlichkeit im kurzwelligen Teil des eingestrahlten Sonnenspektrums bestimmt. Soll die Blauempfindlichkeit weiter gesteigert werden, d.h. die Kurzschlussstromdicht erhöht werden, so müssen die Eindringtiefe und die Oberflächenkonzentration des Phosphors der n+-Schicht erniedrigt werden. Das hat dann zur Folge, dass der Kontaktwiderstand zwischen der Ag-Metallisierung und der n-dotierten Siliziumschicht ansteigt, was sich dann wiederum in einem sinkenden Füllfaktor der Hellkennlinie der Solarzelle und damit durch abnehmende Effizienz äußert.

Ein Weg, bei abnehmender Phosphor-Oberflächenkonzentration einen geringen Übergangswiderstand zwischen dem Silizium und der Metallkontaktierung zu gewährleisten, besteht in der Verwendung von Zwischenschichten von Metallen mit niedrigen Barrierenhöhen, z.B. Nickel oder Titan. Das bedeutet jedoch auch den Übergang zu anderen Metallisierungstechnologien wie z.B. der stromlosen Metallabscheidung oder der Aufdampftechnik. Diese Verfahren sind allerdings nicht massenfertigungstauglich und außerdem mit deutlich höheren Fertigungskosten belastet.

Aufgabe der vorliegenden Erfindung ist es eine Solarzelle mit erhöhter Blauempfindlichkeit und ein kostengünstiges Verfahren zu ihrer Herstellung bereitzustellen.

Diese Aufgabe wird mit dem Verfahren nach dem Patentanspruch 1 gelöst.

Um die oben beschriebenen beiden entgegengesetzten Randbedingungen in Einklang zu bringen, wird erfindungsgemäß bei der n-Dotierung eine sogenannte selektive Emitterstruktur vorgesehen. Hierbei wird der flächenmäßig nur sehr kleine Anteil unter der Vorderseitenkontaktierung mit einer hohen n-Dotierung versehen, während die anderen Bereiche mit einer niedrigen n-Dotierung versehen werden, um eine hohe Blauempfindlichkeit zu gewährleisten.

Erfindungsgemäß wird die n+-Schicht daher in zwei Bereiche aufgeteilt. Der eine, flächenmäßig weit überwiegende Anteil der Waferoberfläche zwischen den metallisierten Bereichen (Vorderseitenkontaktierung), wird nur schwach mit Phosphor dotiert, um eine hohe Blauempfindlichkeit zu gewährleisten.

Der andere, flächenmäßig nur sehr kleine Anteil der Waferoberfläche unter der Metallisierung (Vorderseitenkontaktierung) wird stark mit Phosphor dotiert, um einen niedrigen Kontaktwiderstand sicherzustellen. Die Verwendung einer Siebdruckpaste mit einer oxidätzenden Komponente ermöglicht auch hier eine kostengünstige Fertigung der selektiven Emitterschicht durch einfache Strukturierung der Oxidschicht.

Die Erfindung stellt daher ein kostengünstiges Verfahren zum Herstellen einer Solarzelle mit einer selektiven Emitterschicht bereit.

Um diese selektive Emitterstruktur in den oben beschriebenen Aufbau einer kristallinen Silizium-Solarzelle zu integrieren, ist eine Maskierung erforderlich, die beispielsweise durch eine strukturierte Oxidschicht realisiert werden kann. Diese Oxidschicht muss allerdings in einem eigens dafür erforderlichen Prozessschritt erzeugt werden.

Es ist bekannt, Oxidschichten nach der photolithographischen Methode oder mit Laserstrahlen zu strukturieren. Diese Verfahren sind allerdings verhältnismäßig kostenaufwendig und daher für eine Anwendung im Low-Cost Solarzellenbereich nicht geeignet.

Das erfindungsgemäße Verfahren umfasst einen Schritt zur Strukturierung einer auf einem Trägermaterial aufgebrachten Oxidschicht. Dazu wird nach dem Siebdruckverfahren eine Siebdruckpaste, die eine oxidätzende Komponente enthält, durch eine Druckschablone auf die Oxidschicht gedruckt und die aufgedruckte Siebdruckpaste nach einer vorgegebenen Einwirkungszeit wieder entfernt.

Erfindungsgemäß wird also das an sich bekannte Siebdruckverfahren dazu verwendet, um eine auf einem Trägermaterial aufgebrachte Oxidschicht zu strukturieren. Hierzu wird die Siebdruckpaste mit einer oxidatzenden Komponente versehen. Auf allen Flächenbereichen, die mit der Paste bedruckt werden, wird das Oxid geätzt, auf nicht-bedruckten Flächenbereichen bleibt das Oxid dagegen erhalten.

Der Ätzprozess wird durch Waschen der Siliziumscheibe in Wasser bzw. einem geeigneten Lösemittel beendet. Dieser Prozess kommt also ohne Photo-Resistmasken mit den zugehörigen Prozessschritten oder aufwendigen Lasergeräten zur Strukturierung aus, sondern benötigt lediglich eine Siebdruckvorrichtung. Der Prozess ist daher automatisierbar und für die kostengünstige Produktion von großen Stückzahlen im industriellen Maßstab geeignet.

Nach einer bevorzugten Ausführungsform besteht die oxidätzende Komponente aus Flusssäure (HP) und/oder aus Ammoniumfluorid (NH₄F) und/oder aus Ammoniumhydrogenfluorid (NH₄HF₂). Flusssäure ist eine wäserige Lösung von Fluorwasserstoff, HF. Handelsübliche Flusssäure enthält etwa 40 Gew.-% HF und löst Quarz und Silicate. Flusssäure (HF) und/oder aus Ammoniumfluorid (NH₄F) und/oder Ammoniumhydrogenfluorid (NH₄HF₂) können daher zum Ätzen von Glas und Metallen und insbesondere zum Ätzen von Siliziumoxid verwendet werden.

Nach einer weiteren bevorzugten Ausführungsform ist vorgesehen, dass die oxidätzende Komponente einen Anteil von 10 - 20 Volumenprozent an der Siebdruckpaste aufweist. Es hat sich gezeigt, dass mit diesem Anteil die Einwirkzeit besonders gut steuerbar ist. Je nach Dicke der Oxidschicht beträgt die Einwirkzeit beispielsweise zwischen 30 s und 2 min.

Nach einer bevorzugten Ausführungsform wird die n-Dotierung durch eine Phosphor-Dotierung eingebracht. Das beim Einbringen der Phosphor-Dotierung entstehende Phosphorglas (POCl₃) wird vorzugsweise in einem nachfolgenden Ätzschritt wieder entfernt.

Nach einer weiteren bevorzugten Ausführungsform wird die Vorderseite mit einer Silbersiebdruckpaste kontaktiert.

Ein weiteres Problem ist die Kontaktierung der Rückseite einer Solarzelle. Bei der Siebdruckkontaktierung der Solarzellenrückseite muss Silizium mit einer Grunddotierung um 1.5E16 Atomen/cm³ mit Ag verbunden werden. Dies gelingt nur mit einem hohen Übergangswiderstand, der allerdings den Füllfaktor der Solarzelle stark beeinträchtigt. Um den Übergangswiderstand zu reduzieren, muss die Dotierung des Siliziums auf der Waferrückseite in den Bereich von ca. 10E19 Atomen/cm³ angehoben werden. Dazu existieren unterschiedliche Verfahren.

Bei Solarzellen ohne Back Surface Field (BSF) wird die Dotierung der Rückseite durch eine Beimischung von Aluminium in die Ag-Siebdruckpaste erzeugt. Aluminium bildet mit Silizium schon bei ca. 577°C eine Legierung. Bei Einbrennen der Metallisierung bildet der Aluminiumanteil der Ag-Paste bei Temperaturen oberhalb ca. 577°C mit dem Silizium eine Schmelze. Bei Abkühlung nach dem Einbrennen rekristallisiert die Schmelze, wobei das verfestigte Silizium bis zur Löslichkeitsgrenze im Bereich von lOE19 Atomen/cm³ mit Aluminium dotiert wird. Bei dieser Dotierungskonzentration kann Silizium mit niedrigem Übergangswiderstand mit Ag kontaktiert werden.

Eine andere Klasse stellen die Solarzellen mit Back Surface Field (BSF) dar. Beim Versuch, die Dicke von Siliziumsolarzellen zu reduzieren, wird ein abnehmender Wirkungsgrad der Solarzelle beobachtet. Dies ist zum einen auf die bei dünnerer Absorptionslänge nicht mehr vollständige Absorption des Sonnenlichts zurückzuführen. Zum anderen werden vermehrt Ladungsträger in der Nähe der Rückseite erzeugt, wobei Minoritätsladungsträger durch Diffusion die Rückelektrode erreichen können und dadurch den durch die Majoritätsladungsträger erzeugten Strom reduzieren. Durch eine hockdotierte Schicht auf der Rückseite ist es möglich, ein der Diffusion der Minoritätsladungsträger entgegenwirkendes Feld, ein sogenanntes Back-Surface-Field (BSF) zu erzeugen. Bei einem SolarzellenaufLau mit einem p-dotierten Solarzellenkörper und einem n+-dotierten Emitter an der Lichteinfalls- bzw. Vorderseite der Solarzelle ist dazu eine p+-Dotierung an der Rückseite erforderlich. Zu deren Erzeugung wird vielfach Aluminium vorgeschlagen, welches sich als dünne Schicht zum Beispiel durch Aufdampfen auf der Rückseite aufbringen und durch einen Temperschritt eintreiben bzw. einlegieren lässt. Möglich ist es auch, die p+-Dotierung durch das Aufbringen aluminiumhaltiger Rückkontakte und entsprechendes Eintreiben des Aluminiums zu erzeugen. Weiterhin ist es möglich, Aluminium aus einer Feststoff- Diffusionsquelle in das Solarzellensubstrat einzudiffundieren. Diese ist allerdings mit dem Nachteil verbunden, dass das Solarzellensubstrat auf beiden Seiten aluminiumdotiert wird, wobei eine p+pp+-Struktur erzeugt wird.

Auch Bor ist zur Erzeugung einer p-Dotierung geeignet. Ein entsprechendes Back-Surface-Field kann dabei durch Gasdiffusion einer entsprechend flüchtigen bzw. gasförmigen Borverbindung, durch Aufbringen einer borhaltigen Siliziumschicht auf der Rückseite oder durch Aufbringen einer flüssigen dotierstoffhaltigen Lösung erzeugt werden. Bei den für das Eintreiben der Dotierung erforderlichen Temperaturen wird jedoch aufgrund der hohen Flüchtigkeit der Borverbindungen stets eine Rundum-Diffusion beobachtet, die durch eine Maskierung der nicht zu dotierenden Solarzellenbereiche verhindert werden muss.

Aus der DE 33 40 874 C2 ist ein Verfahren zur Herstellung eines Back-Surface-Fields bekannt, bei dem der entsprechende Dotierstoff aus einer dotierstoffhaltigen Schicht in den Haltleiterkörper eingetrieben wird.

Die Herstellung eines Back-Surface-Fields durch direkte Diffusion oder durch Eintreiben aus einer Dotierstoffschicht ist aus der US 4,158,591 bekannt. Die nicht zu dotierende Oberfläche des Wafers kann dabei durch Abdecken mit einem zweiten Wafer geschützt werden.

Die verfahrensmäßig einfach herzustellende p+-Dotierung mit Aluminium hat den Nachteil einer erhöhten Korrosionsanfälligkeit. Im Laufe der Zeit können sich aluminiumhaltige Schichtbereiche zersetzen und ablösen, was zur Beschädigung der Rückseitenkontakte und zur Reduzierung der Solarzellenleistung führen kann. Eine Lösung dieses Problems ist aus DE 195 08 712 C2 bekannt. Die grundlegende Idee ist hier, die p+-Dotierung des Back-Surface-Fields durch Austreiben von Bor aus einer borhaltigen Diffusionsquellschicht zu erzeugen. Die nicht gewünschte Dotierung von Rändern und Vorderseite des Wafers wird verhindert, indem das Austreiben in einer sauerstoffhaltigen Atmosphäre bei hohen Temperaturen von 900 bis 1200°C vorgenommen wird. Unter diesen Bedingungen bildet sich an Rändern und Vorderseite des Wafers sofort eine Oxidschicht aus, die zur Maskierung dient und damit die unerwünschte Dotierung an diesen Stellen verhindert. Nach dem Eintreiben kann sowohl die Oxid- als auch die Diffusionsquellschicht durch einen einfachen Ätzschritt entfernt werden.

Als weitere Lösung der Erfindung wird nunmehr vorgeschlagen, diese sich ohnehin bildende Oxidschicht bei der Erzeugung des Back-Surface-Fields zur Maskierung der Vorderseite bei der Herstellung einer selektiven Emitterschicht zu nutzen.

Eine weitere erfindungsgemäße Lösung besteht daher in einem Verfahren zum Erzeugen einer Solarzelle mit einer selektiven Emitterschicht auf der Lichteinfallseite entspreched der hiervor beschriebenen Erfindung, wobei ein Back-Surface-Field auf der Rückseite dadurch erzeugt wird, dass vor dem Erzeugen der Oxidschicht auf dem p-dotierten Silizium-Wafer eine Diffusionsquellschicht, die Bor als Dotierstoff enthält, auf der Rückseite des Silizium-Wafers aufgebracht wird, und wobei das Silizium-Wafer in einer Sauerstoff enthaltenden Atmosphäre bei einer Temperatur von 900 bis 1200°C behandelt wird zum Erzeugen der Oxidschicht und zum Eintreiben des Dotierstoffs.

Nach einer bevorzugten Ausführungsform wird die Diffusionsquellschicht vor dem Einbringen der ganzflächig schwachen n-Dotierung entfernt.

Nach einer weiteren bevorzugten Ausführungsform wird n-Dotierung am Rand des Wafers aufgetrennt.

Nach einer weiteren bevorzugten Ausführungsform wird ein Rückkontakt auf der Rückseite aufgebracht.

Das an sich bekannte Verfahren zur Herstellung eines BSF-Feldes aus der DE 195 08 712 C2 kann also besonders vorteilhaft mit der erfindungsgemäßen Strukturierung einer Oxidschicht kombiniert werden, da sich die Oxidschicht zur Maskierung beim Eintreiben der BSF-Dotierung ausbildet, ohne dass ein weiterer Prozessschritt erforderlich ist.

Ansonsten ergeben sich alle weiteren Vorteile des aus der DE 195 08 712 C2 bekannten Verfahrens.

Beispielsweise ist zu beachten, dass die Erzeugung des Back-Surface-Fields (BSF) vor der Erzeugung des Halbleiterübergangs erfolgt, also vor der Eindiffusion von Phosphor auf der Vorderseite der Solarzelle. Die gewählten hohen Temperaturen sorgen für ein tiefes Eintreiben der Bordotierung. Diese ist dann auch gegenüber sämtlichen

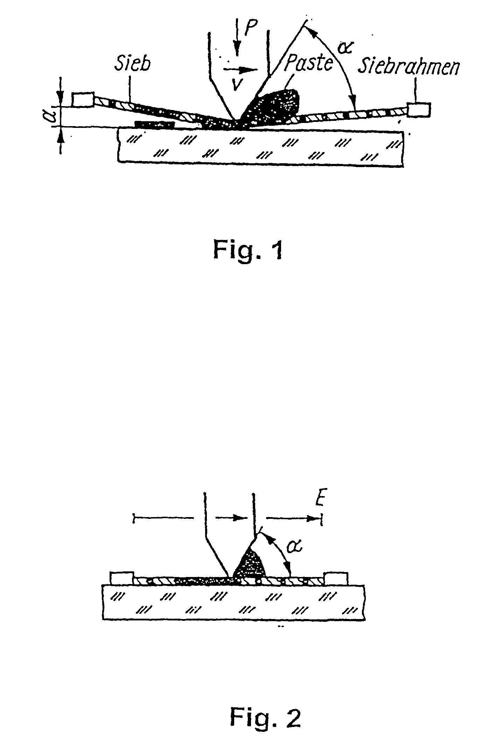

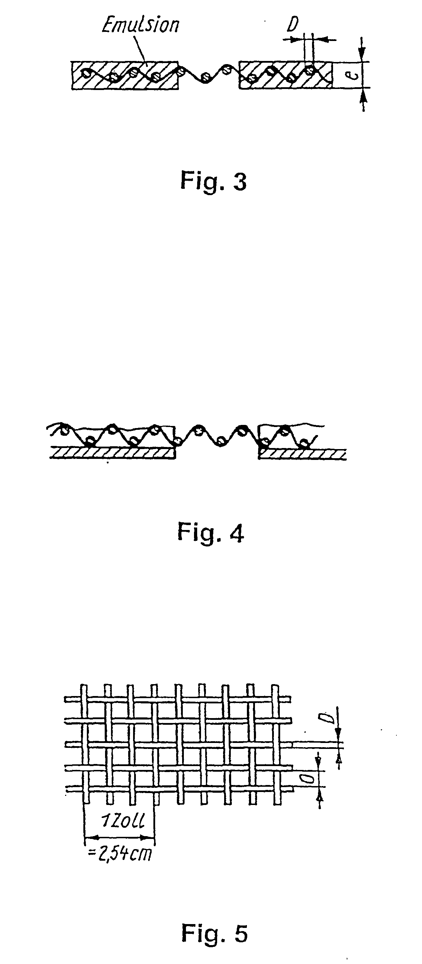

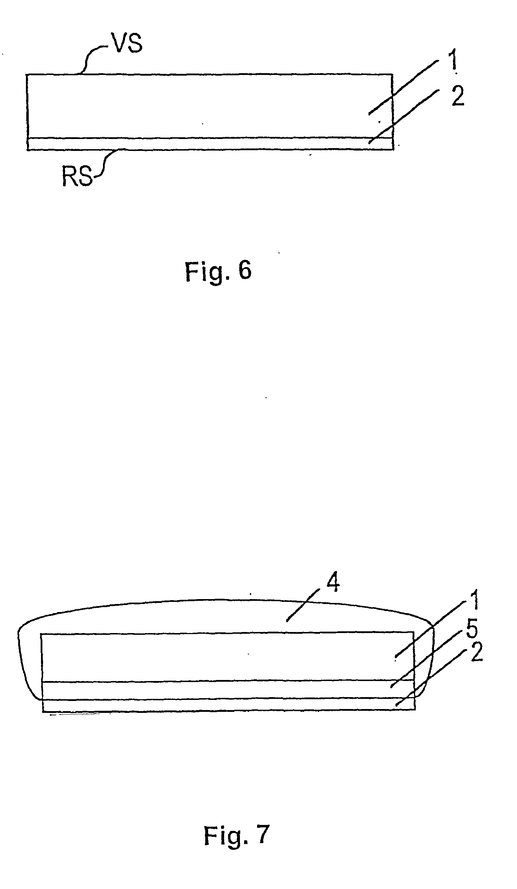

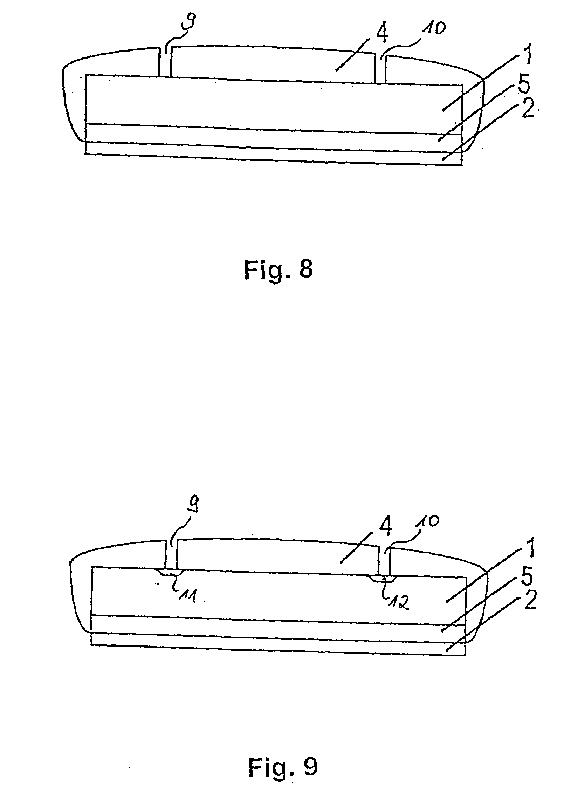

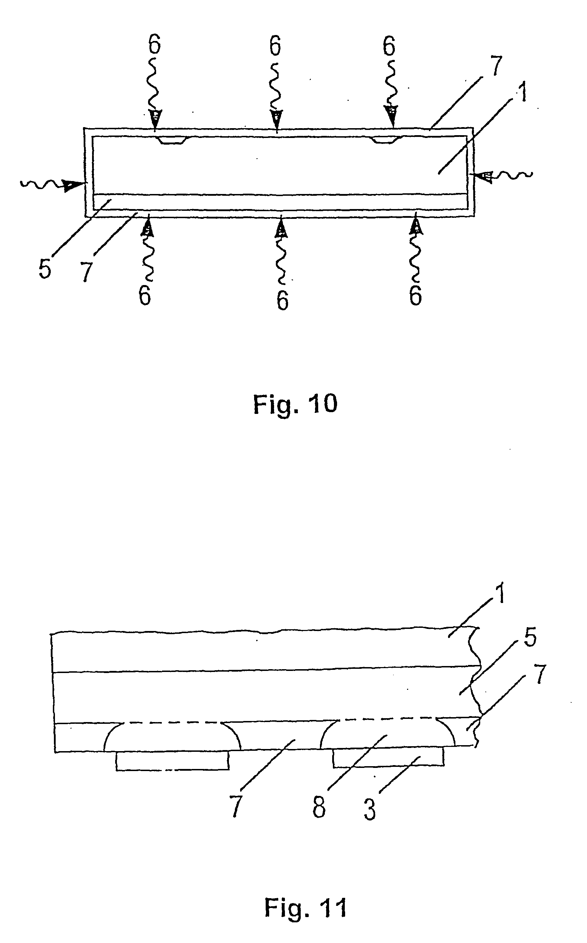

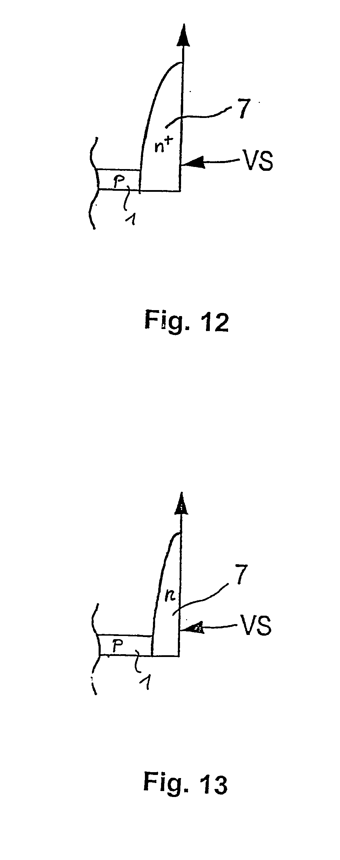

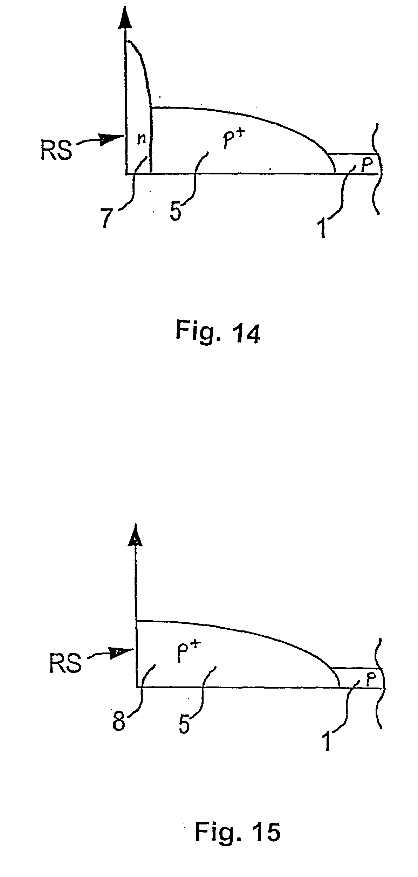

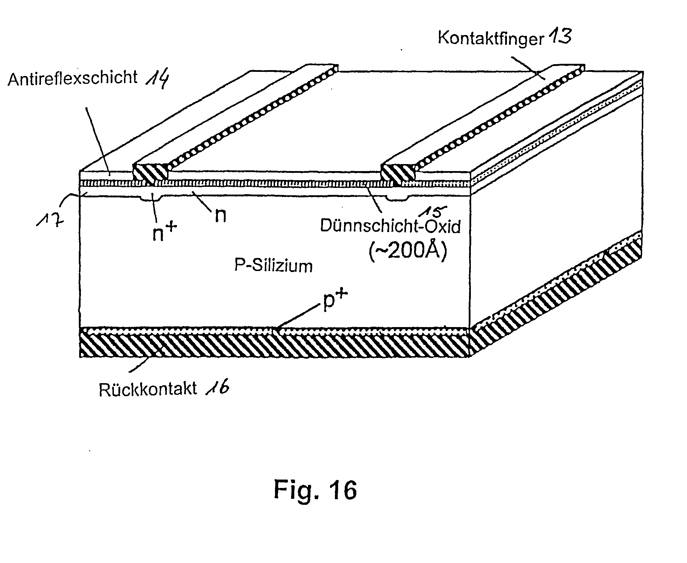

## Patentansprüche

1. Verfahren zum Herstellen einer Solarzelle mit einer selektiven Emitterschicht auf der Lichteinfallseite, umfassend die folgenden Schritte:
- Bereitstellen eines p-dotierten Silizium-Wafers mit einer Lichteinfallseite und einer Rückseite;
- Erzeugen einer Oxidschicht auf der Lichteinfallseite des p-dotierten Silizium-Wafers;
- Strukturierung der Oxidschicht zur Ausbildung strukturierter Bereiche, indem mittels Siebdruck eine Siebdruckpaste, die eine oxidätzende Komponente enthält, durch eine Druckschablone auf die Oxidschicht gedruckt wird, und wobei die aufgedruckte Siebdruckpaste nach einer vorgegebenen Einwirkungszeit wieder entfernt wird;
- Einbringen einer selektiven hohen n-Dotierung in den strukturierten Bereichen zur Ausbildung der selektiven Emitterschicht;
- Entfernen der Oxidschicht;
- Einbringen einer ganzflächig schwachen n-Dotierung über die selektiven hohen n-Dotierungen; und
- Kontaktierung der Lichteinfallseite in Bereichen der selektiven hohen n-Dotierung.

2. Verfahren nach Anspruch 1, **dadurch gekennzeichnet, dass** die oxidätzende Komponente aus Flusssäure (HF) und/oder aus Ammoniumfluorid (NH₄F) und/oder aus Ammoniumhydrogenfluorid (NH₄HF₂) besteht.

3. Verfahren nach einem der Ansprüche 1-2, **dadurch gekennzeichnet, dass** die oxidätzende Komponente einen Anteil von 10 - 20 Volumenprozent an der Siebdruckpaste aufweist.

4. Verfahren nach einem der Ansprüche 1-3, **dadurch gekennzeichnet, dass** die Einwirkungszeit zwischen 30 s und 2 min beträgt.

5. Verfahren nach einem der Ansprüche 1-4, wobei die Kontaktierung der Lichteinfallseite mittels Siebdruck vorgenommen wird.

6. Verfahren nach einem der Ansprüche 1-5, **dadurch gekennzeichnet, dass** die n-Dotierung durch eine Phosphor-Dotierung eingebracht wird.

7. Verfahren nach einem der Ansprüche 1-6, **dadurch gekennzeichnet, dass** das beim Einbringen der Phosphor-Dotierung entstehende Phosphorglas (POCl₃) in einem nachfolgenden Ätzschritt wieder entfernt wird.

8. Verfahren nach einem der Ansprüche 1-7, **dadurch gekennzeichnet, dass** die Vorderseite mit einer Silbersiebdruckpaste kontaktiert wird.

9. Verfahren nach einem der Ansprüche 1-8, wobei weiterhin ein Back-Surface-Field auf der Rückseite des Silizium-Wafers erzeugt wird, indem vor dem Erzeugen der Oxidschicht auf dem p-dotierten Silizium-Wafer eine Diffusionsquellschicht, die Bor als Dotierstoff enthält, auf der Rückseite des Silizium-Wafers aufgebracht wird, und wobei das Silizium-Wafer in einer Sauerstoff enthaltenden Atmosphäre bei einer Temperatur von 900 bis 1200°C behandelt wird zum Erzeugen der Oxidschicht und zum Eintreiben des Dotierstoffs.

10. Verfahren nach Anspruch 9, wobei die Diffusionsquellschicht vor dem Einbringen der ganzflächig schwachen n-Dotierung entfernt wird.

11. Verfahren nach Anspruch 9 oder 10, weiterhin umfassend den Schritt der Auftrennung der n-Dotierung am Rand des Wafers.

12. Verfahren nach einem der Ansprüche 9-11, wobei ein Rückkontakt auf der Rückseite aufgebracht wird.

13. Verfahren nach einem der Ansprüche 9-12, **dadurch gekennzeichnet, dass** als Diffusionsquellschicht ein Bordotierlack oder eine Bordotierpaste aufgebracht wird.

14. Verfahren nach einem der Ansprüche 9-13, **dadurch gekennzeichnet, dass** die Diffusionsquellschicht und Oxidschicht durch Ätzen mit HF-Lösung entfernt werden.

15. Verfahren nach Anspruch 11, wobei das Auftrennen der n-Dotierung am Rand des Wafers durch Abätzen der Außenränder erfolgt.

16. Verfahren nach einem der Ansprüche 9 - 15, **dadurch gekennzeichnet, dass** die Rückseite mit einer Silbersiebdruckpaste kontaktiert wird, die 1 bis 3 Gewichtsprozent Aluminium enthält.

17. Verfahren nach Anspruch 12, wobei die Rückseite in Bereichen derart kontaktiert wird, dass zwischen den von dem Rückkontakt bedeckten Bereichen die Bordotierung von einer flacheren n- Dotierung überkompensiert ist.

18. Verfahren nach einem der Ansprüche 9 - 17, **dadurch gekennzeichnet, dass** eine Antireflexschicht auf der Lichteinfalleeite und eine Passivierungsschicht auf der Rückseite aufgebracht ist.

19. Verfahren nach einem der Ansprüche 1-18, wobei zur Strukturierung der Oxidschicht eine Siebdruckpaste mit einem Bindemittel und einer oxidätzenden Komponente verwendet wird.

20. Verfahren nach einem der Ansprüche 1-19, wobei zur Strukturierung der Oxidschicht eine Siebdruckpaste verwendet wird mit einer Viskosität zwischen 10 und 500 Pa s, vorzugsweise zwischen 50 und 200 Pa s.

21. Verfahren nach Anspruch 19, wobei das Bindemittel aus Tapetenkleister besteht.

22. Verfahren nach Anspruch 19, wobei das Bindemittel aus einem Epoxidharz besteht.

## Claims

1. A method for manufacturing a solar cell with a selective emitter layer on the side facing the light, consisting of the following steps:
- providing a p-doped silicon wafer with a side facing the light and a rear side;
- producing an oxide layer on the side facing the light of the p-doped silicon wafer;
- structuring the oxide layer for producing structured areas, whereby, by means of a silk-screen printing process, a squeegee paste containing an oxide-etching component is printed onto the oxide layer via a pattern stencil, and whereby the printed-on squeegee paste is removed after a predetermined dwell time;
- applying a selective high degree of n-doping in the structured areas for producing the selective emitter layer;
- removing the oxide layer;
- applying weak n-doping to the entire surface over the selective high n-doping areas; and
- bonding the side facing the light in the areas of the selective high n-doping.

2. A method according to claim 1, **characterized in that** the oxide-etching component consists of hydrofluoric acid (HF) and/or ammonium fluoride (NH₄F) and/or ammonium hydrogen fluoride (NH₄HF₂).

3. A method according to one of claims 1 to 2, **characterized in that** the oxide-etching component constitutes a proportion of 10 % to 20 % by volume of the squeegee paste.

4. A method according to one of claims 1 to 3, **characterized in that** the dwell time ranges from 30 seconds to 2 minutes.

5. A method according to one of claims 1 to 4, wherein the bonding of the side facing the light is made by using the silk-screen printing process.

6. A method according to one of claims 1 to 5, **characterized in that** the n-doping, is applied by means of phosphor doping.

7. A method according to one of claims 1 to 6, **characterized in that** the phosphor glass (POCl₃) produced during application of the phosphor doping is removed in a subsequent etching process.

8. A method according to one of claims 1 to 7, **characterized in that** the front side is bonded with a squeegee paste.

9. A method according to one of claims 1 to 8, wherein, furthermore, a back surface field is produced on the rear side of the silicon wafer by applying to the rear side of the p-doped silicon wafer a diffusion source layer containing boron as a doping agent before producing the oxide layer, and wherein the silicon wafer is treated in an oxygenous atmosphere at a temperature of 900°C to 1200° C to enable the creation of the oxide layer and the penetration of the doping agent

10. A method according to claim 9, wherein the diffusion source layer is removed before applying the weak n-doping to the entire surface.

11. A method according to claim 9 or 10, furthermore comprising the step of detaching of the n-doping at the edge of the wafer.

12. A method according to one of claims 9 to 11, wherein a rear contact is applied to the rear side.

13. A method according to one of claims 9 to 12, **characterized in that** a boron-doped coating or a boron paste is applied to act as a diffusion source layer.

14. A method according to one of claims 9 of 13, **characterized in that** the diffusion source layer and oxide layer are removed by etching with an HF solution.

15. A method according to claim 11, **characterized in that** the separation of the n-doping at the edge of the wafer is carried out by etching of the outside edges.

16. A method according to one of claims 9 to 15, **characterized in that** the rear side is bonded with a silver squeegee paste containing 1 % to 3 % by weight of aluminium.

17. A method according to claim 1, wherein the rear side in certain areas is bonded in such a way that the boron doping of a flatter n-doping is overcompensated between the areas covered by the rear contact.

18. A method according to one of claim 9 to 17, **characterized in that** an anti-reflection layer is applied to the side facing the light and a passivation layer to the rear side.

19. A method according to one of claims 1 to 18, wherein a squeegee paste consisting of a binding agent and an oxide-etching component is applied for structuring the oxide layer.

20. A method according to one of claims 1 to 19, wherein a squeegee paste, having a viscosity of between 10 and 500 Pa-s, and preferably of between 50 and 200 Pa-s, is applied for structuring the oxide layer.

21. A method according to claim 18, wherein the binding agent consists of wallpaper paste.

22. A method according to claim 19, wherein the binding agent consists of an epoxy resin.

## Revendications

1. Procédé de fabrication d'une cellule solaire dotée d'une couche émettrice sélective sur le côté d'incidence de la lumière, comprenant les étapes suivantes :
- la mise à disposition d'une plaquette de silicium dopée de type p présentant une face d'incidence de la lumière et une face arrière ;
- la production d'une couche d'oxyde sur le côté d'incidence de la lumière de la plaquette de silicium dopée de type p ;
- la structuration de la couche d'oxyde pour former des zones structurées par impression par sérigraphie, avec une pâte de sérigraphie qui contient des composants oxydants au travers d'un pochoir sur la couche d'oxyde, dans laquelle la pâte de sérigraphie est à nouveau retirée après un temps d'action prédéterminé ;
- la mise en place d'un dopage de type n sélectif dans les zones structurées pour former la couche émettrice sélective ;
- l'élimination de la couche d'oxyde ;
- la mise en place d'un dopage de type n sur toute la surface sur les dopages n hautement sélectifs ; et
- la mise en contact du côté d'incidence de la lumière dans les zones de dopage n hautement sélectif.

2. Procédé selon la revendication 1, **caractérisé en ce que** les composants oxydants sont constitués d'acide fluorhydrique (HF) et/ou de fluorure d'ammonium (NH₄F) et/ou de bifluorure d'ammonium (NH₄F).

3. Procédé selon l'une quelconque des revendications 1 à 2, **caractérisé en ce que** le composant oxydant présente de 10 à 20 % en volume de pâte de sérigraphie.

4. Procédé selon l'une quelconque des revendications 1 à 3, **caractérisé en ce que** le temps d'action est de 30 s à 2 min.

5. Procédé selon l'une quelconque des revendications 1 à 4, dans lequel la mise en contact du côté d'incidence de la lumière est réalisée par sérigraphie.

6. Procédé selon l'une quelconque des revendications 1 à 5, **caractérisé en ce que** le dopage n s'effectue par un dopage au phosphore.

7. Procédé selon l'une quelconque des revendications 1 à 6, **caractérisé en ce que** le verre au phosphore (POCl₃) produit lors de la mise en place du dopage au phosphore est à nouveau éliminé dans une étape de corrosion.

8. Procédé selon l'une quelconque des revendications 1 à 7, **caractérisé en ce que** la face avant est mise en contact avec une pâte de sérigraphie.

9. Procédé selon l'une quelconque des revendications 1 à 8, dans lequel une couche BSF (back-surface-field) est produite sur la face arrière de la plaquette de silicium, en plaçant avant de produire la couche d'oxyde sur la plaquette de silicium dopée de type p, une couche de source de diffusion qui contient du bore comme substance de dopage, sur la face arrière de la plaquette de silicium et dans lequel la plaquette de silicium est traitée dans une atmosphère contenant de l'oxygène à une température de 900 à 1200° C pour produire une couche d'oxyde et pour insérer la substance de dopage.

10. Procédé selon la revendication 9, dans lequel la couche de source de diffusion est éliminée avant la mise en place du dopage faible de type n sur toute la surface.

11. Procédé selon la revendication 9 ou 10, comprenant en outre l'étape de séparation du dopage n sur le bord de la plaquette.

12. Procédé selon l'une quelconque des revendications 9 à 11, dans lequel un contact de retour est mis en place sur la face arrière.

13. Procédé selon l'une quelconque des revendications 9 à 12, **caractérisé en ce qu'**une laque de dopage au bore ou une pâte de dopage au bore est mise en place en tant que couche de source de diffusion.

14. Procédé selon l'une quelconque des revendications 9 à 13, **caractérisé en ce que** la couche de source de diffusion et la couche d'oxyde sont éliminées par corrosion avec une solution de HF.

15. Procédé selon la revendication 11, dans lequel la séparation du dopage n au bord de la plaquette s'effectue par corrosion des bords extérieurs.

16. Procédé selon l'une quelconque des revendications 9 à 15, **caractérisé en ce que** la face arrière est mise en contact avec une pâte de sérigraphie qui contient 1 à 3 % en poids d'aluminium.

17. Procédé selon la revendication 12, dans lequel la face arrière est mise en contact dans les zones de telle sorte qu'entre les zones revêtues par l'élément de contact arrière, le dopage au bore soit surcompensé par un dopage de type n plat.

18. Procédé selon l'une quelconque des revendications 9 à 17, **caractérisé en ce que** la couche anti-reflet est placée sur le côté d'incidence de la lumière et une couche de passivation est placée sur la face arrière.

19. Procédé selon l'une quelconque des revendications 1 à 18, dans lequel pour structurer la couche d'oxyde, on utilise une pâte de sérigraphie avec un agent liant et un composant oxydant.

20. Procédé selon l'une quelconque des revendications 1 à 18, dans lequel pour structurer la couche d'oxyde, on utilise une pâte de sérigraphie présentant une viscosité entre 10 et 500 Pa.s, de préférence entre 50 et 200 Pa.s.

21. Procédé selon la revendication 19, dans lequel l'agent liant est constitué de colle de papier peint.

22. Procédé selon la revendication 19, dans lequel l'agent liant est constitué d'une résine époxy.
